# EUROPEAN PATENT SPECIFICATION

(11) **EP 1 806 618 B1**
(45) Date of publication and mention of the grant of the patent: **09.06.2010**
(21) Application number: 05799121.8
(22) Date of filing: 28.10.2005
(51) Int. Cl.: G03F 7/023, C08F 212/08, C08F 212/14, C08G 8/38, G03F 7/075, G03F 7/40, G03F 7/022

(54) **POSITIVE PHOTOSENSITIVE INSULATING RESIN COMPOSITION AND CURED PRODUCT THEREOF**
POSITIV LICHTEMPFINDLICHE ISOLIERENDE HARZZUSAMMENSETZUNG UND AUSGEHÄRTETES PRODUKT DAVON
COMPOSITION DE RÉSINE ISOLANTE PHOTOSENSIBLE POSITIVE ET PRODUIT DURCI FORMÉ À PARTIR DE CELLE-CI

(30) Priority: 29.10.2004 JP 2004316655; 29.10.2004 JP 2004316656
(43) Date of publication of application: 11.07.2007
(73) Proprietor: JSR Corporation, Tokyo 104-0045 (JP)
(72) Inventor: ITO, Atsushi, c/o JSR CORPORATION, Tokyo 1040045 (JP); YOKOYAMA, Ken-ichi, c/o JSR CORPORATION, Tokyo 1040045 (JP); INOMATA, Katsumi, c/o JSR CORPORATION, Tokyo 1040045 (JP); IWANAGA, Shin-ichiro, c/o JSR CORPORATION, Tokyo 1040045 (JP)
(74) Representative: TBK-Patent
(86) International application number: PCT/JP2005/019865
(87) International publication number: WO 2006/046687

(56) References cited:
- JP-A- 7 306 309
- JP-A- 7 306 309
- JP-A- 11 015 163
- JP-A- 2003 075 997
- JP-A- 2003 215 795
- JP-A- 2004 240 144
- US-A1- 2004 094 752
- US-A1- 2004 126 696

## Description

### TECHINCAL FIELD

The present invention relates to positive photosensitive insulating resin compositions used for surface-protective films (cover coat films) or interlaminar insulating films (passivation films) in semiconductor elements and the like, and to cured products (insulating products) obtainable by curing the resin compositions. More specifically, it relates to cured products having not only excellent resolution properties as a permanent film resist but also excellent electrical insulating properties, thermal shock resistance and adhesion, and to positive photosensitive insulating resin compositions capable of preparing the cured products.

### TECHNICAL BACKGROUND

Conventionally, a polyimide resin and a polybenzoxazole resin having excellent heat resistance and mechanical properties have been widely used in interlaminar insulating films and surface protective films used for semiconductor elements in electronic devices. Furthermore, a photosensitive polyimide and a photosensitive polybenzoxazole resin obtainable by giving photosensitivity to the polyimide resin and polybenzoxazole resin in order to improve productivity and film forming accuracy have been studied variously. For example, a negative resin in which a photo-crosslinking group is introduced into a polyimide precursor by ester bonding or ion bonding has been used practically. As the positive resin compositions, JP-A-H5(1993)-5996 and JP-A-2000-98601 disclose compositions made up of a polyimide precursor and a quinone diazide compound, and JP-A-H11(1999)-237736 discloses a composition made up of a polybenzoxazole precursor and a quinone diazide compound. These systems, however, have problems such as film decrease (volume shrinkage) after curing, multi-stage baking at curing and atmosphere control. Therefore, it is indicated that it will be hard to use these compositions in the industrial production.

Various compositions are proposed in order to improve properties of the photosensitive resin compositions. For example, positive photosensitive resin compositions obtainable by using a polyphenylene oxide resin are disclosed in JP-A-2000-275842 and JP-A-2001-312064. These compositions, however, have a problem in a property balance among resolution, electrical insulating properties, thermal shock properties and adhesion for use as an insulating resin.

There is disclosed a positive photosensitive resin composition obtainable by using a hydroxystyrene (co)polymer as an alkali-soluble resin. As such a composition, JP-A-H7(1995)-140648 (Patent document 1) discloses a thermosetting photosensitive material made up of a polyvinyl phenol as an alkali-soluble resin, a specific photosensitizer, a specific thermosetting agent and a solvent. JP-A-H6(1994)-43637 (Patent document 2) discloses a resin composition containing an alkali-soluble resin, a quinone diazide compound and a crosslinking agent, and also discloses a copolymer having a p-hydroxystyrene structure as the alkali-soluble resin.

Furthermore, JP-A-2003-215789 (Patent document 3) discloses a positive photosensitive resin composition containing an alkali-soluble resin with a phenolic hydroxyl group, a quinone diazide compound, crosslinked fine particles, a curing agent and a solvent. JP-A-2003-215795 (Patent document 4) discloses that the above positive photosensitive resin composition further contains an acid generating agent and also discloses polyhydroxystyrene and a copolymer thereof as the alkali-soluble resin. It further discloses that the alkali-soluble resin has a prescribed molecular weight from the standpoint of resolution, thermal shock properties and heat resistance of an insulating film formed from the composition, that the crosslinked fine particles are used from the standpoint of thermal shock properties and heat resistance, and that the curing agent is used in a prescribed amount from the standpoint of electrical insulating properties.

These resin compositions, however, cannot form cured products having excellent property balance among resolution, electrical insulating properties, thermal shock properties and adhesion. The polyhydroxystyrene copolymer is used in these resin compositions to enable development of cured products with an alkali aqueous solution. In any of the documents, however, the kind and composition of the polyhydroxystyrene copolymer are not studied in detail, and further, they do not describe the idea of improving properties other than alkali developing properties of the resin compositions and the cured products thereof by regulating the kind or the composition of the polyhydroxystyrene copolymer.
Patent document 1: JP-A-H7(1995)-140648
Patent document 2: JP-A-H6(1994)-43637
Patent document 3: JP-A-2003-215789
Patent document 4: JP-A-2003-215795
JP-A-7-306309 discloses a photosensitive composition for colour filters comprising an alkali soluble phenolic resin, a o-naphthoquinone diazide, a crosslinking agent, a pigment, an organic solvent and optionally a hydroxystyrene-styrene copolymer whereas the crosslinking agent is preferably a melamine derivative.

### DISCLOSURE OF THE INVENTION

### PROBLEM TO BE SOLVED BY THE INVENTION

The present invention is intended to solve the problems associated with prior arts, and it is an object of the invention to provide a positive photosensitive insulating resin composition capable of preparing cured products having excellent resolution, electrical insulating properties, thermal shock resistance, adhesion and other properties and suitable for interlaminar insulating films, surface protective films and other uses in semiconductor elements.
It is another object of the invention to provide a cured product obtainable by curing the positive photosensitive insulating resin composition and having excellent resolution, electrical insulating properties, thermal shock properties, adhesion and other properties.

### MEANS FOR SOLVING PROBLEM

The present inventors have earnestly studied to solve the above problems and have found that a positive photosensitive insulating resin composition that contains a polyhydroxystyrene copolymer having specific structural units in specific amounts as an alkali-soluble resin can give a cured product showing remarkably improved electrical insulating properties and thermal shock resistance. Thus, the present invention has been accomplished. The positive photosensitive insulating resin composition of the present invention comprises:
(A) a copolymer comprising
   (A1) 10 to 99 mol% of a structural unit represented by the following formula (1) and
   (A2) 90 to 1 mol% of a structural unit represented by the following formula (2) provided that the amount of total structural units of the copolymer is 100 mol%,

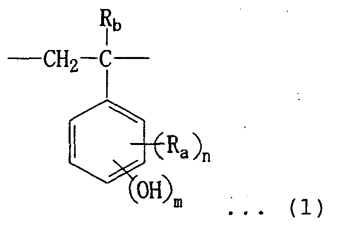

wherein Ra is an alkyl group having 1 to 4 carbon atoms, alkoxy group or aryl group, Rb is hydrogen or a methyl group, n is an integer of 0 to 3 and m is an integer of 1 to 3,

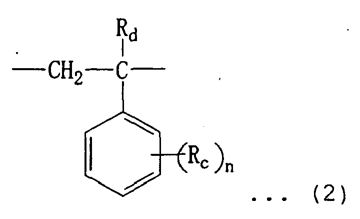

wherein Rc is an alkyl group having 1 to 4 carbon atoms, alkoxy group or aryl group, Rd is hydrogen or a methyl group and n is an integer of 0 to 3;
(B) a quinone diazide group-containing compound;
(C) at least one compound selected from the group consisting of (C1) 1,2-benzene dimethanol, 1,3-benzene dimethanol, 1,4-benzene dimethanol, 2,6-bis(hydroxymethyl)-p-cresol, 2,6-bis(hydroxylmethyl)-4-methylphenol, 5-[1,1-dimethylethyl]2-hydroxy-1,3-benzene dimethanol, 2-hydroxy-1,3,5-benzene trimethanol, 2,6-dimethoxymethyl-4-methylphenol, 2,6-dimethoxymethyl-4-(1,1-dimethylethyl)phenol, 3,3'-methylene bis(2-hydroxy-5-methyl-benzene methanol), 4,4'-(1-methyl ethylidene)bis(2-methyl-6-methoxymethyl phenol), 4,4'-(1-phenyl ethylidene)bis(2-hydroxyethoxy phenol), 3,3',5,5'-tetramethylol-2,2-bis(4-hydroxyphenylpropane), 3,3',5,5'-tetramethoxymethyl-2,2-bis(4-hydroxyphenylpropane), 1,2,4,5-tetramethylol benzene and 1,2,4,5-tetramethoxymethylbenzene, (C2) aromatic aldehyde compounds, (C3) aliphatic aldehyde compounds, (C4) alkyl-etherified amino group-containing compounds and (C5) epoxy group-containing compounds;
(D) a solvent; and
(E) an adhesion assistant selected from trimethoxysilylbenzoic acid, γ-methacryloxy propyl trimethoxy silane, vinyl triacetoxy silane, vinyltrimethoxy silane, γ-isocyanate propyl triethoxy silane, γ-glycidoxy propyl trimethoxy silane, β-(3,4-epoxy cyclohexyl) ethyltrimethoxy silane and 1,3,5-N-tris(trimethoxysilyl propyl) isocyanurate.

The copolymer (A) preferably consists only of 10 to 99 mol% of the structural unit (A1) represented by the formula (1) and 90 to 1 mol% of the structural unit (A2) represented by the formula (2) provided that the total amount of the structural units (A1) and (A2) is 100 mol%.
The structural unit (A2) is preferably represented by the following formula (2').

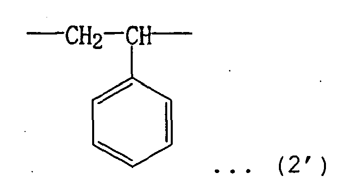

The positive photosensitive insulating resin composition may further contain a phenolic compound (a).
The amount of the phenolic compound (a) is preferably from 1 to 200 parts by weight based on 100 parts by weight of the copolymer (A).
Based on 100 parts by weight of the total of the copolymer (A) and the phenolic compound (a), the amount of the quinone diazide group-containing compound (B) is preferably from 10 to 50 parts by weight and the amount of the compound (C) is preferably from 1 to 100 parts by weight.

The positive photosensitive insulating resin composition preferably further contains crosslinked fine particles (F) having an average particle diameter of 30 to 500 nm, the crosslinked fine particles comprising a copolymer showing glass transition temperatures (Tg) of which at least one glass transition temperature is not higher than 0°C.
The crosslinked fine particles (F) preferably comprise a styrene-butadiene copolymer.

The amount of the crosslinked fine particles (F) is preferably from 0.1 to 50 parts by weight based on 100 parts by weight of the total of the copolymer (A) and the phenolic compound (a).
The cured product of the present invention is obtainable by curing the positive photosensitive insulating resin composition.
The cured product preferably has the following properties:
(i) the resistance value after a migration test is not less than 10¹⁰Ω, and
(ii) the cured product in a form of film undergoes not less than 1000 cycles without being cracked in a thermal shock test wherein 1 cycle consists of cooling at -65°C for 30 min and heating at 150°C for 30 min.

### EFFECTS OF THE INVENTION

The positive photosensitive insulating resin composition according to the present invention can form cured products having excellent resolution, insulating properties, thermal shock resistance and adhesion, with the insulating properties and thermal shock resistance being remarkably improved.
The cured products according to the present invention can form interlaminar insulating films and surface protective films used for cured semiconductor elements, which films are excellent in resolution, electrical insulating properties, thermal shock resistance, adhesion and other properties, with the insulating properties and thermal shock resistance being remarkably improved.

### BRIEF DESCRIPTION OF THE DRAWINGS

Fig. 1 is a sectional view of a base material for evaluation of thermal shock resistance.
Fig. 2 is a schematic view of the base material for evaluation of thermal shock resistance.
Fig. 3 is a schematic view of a base material for evaluation of electrical insulating properties.

### EXPLANATIONS OF LETTERS

1. Copper foil
2. Substrate
3. Base material
4. Copper foil
5. Substrate
6. Base material

### BEST MODE FOR CARRYING OUT THE INVENTION

The positive photosensitive insulating resin composition and the cured product thereof according to the invention will be described in detail below.

### [Positive photosensitive insulating resin composition]

The positive photosensitive insulating resin composition of the present invention may contain a phenolic compound, a crosslinking assistant, crosslinked fine particles, a sensitizer, a leveling agent and other additives, if necessary.

### (A) Copolymer;

The copolymer (A) used in the present invention is a copolymer of a monomer capable of forming the structural unit (A1) represented by the formula (1) and a monomer capable of forming the structural unit (A2) represented by the formula (2), and is an alkali-soluble resin (hereinafter referred to as "alkali-soluble resin (A)").

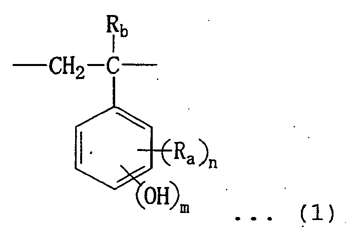

wherein Ra is an alkyl group having 1 to 4 carbon atoms, alkoxy group or aryl group, Rb is hydrogen or a methyl group, n is an integer of 0 to 3 and m is an integer of 1 to 3,

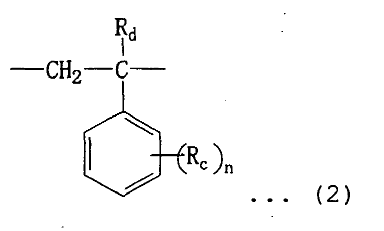

wherein Rc is an alkyl group having 1 to 4 carbon atoms, alkoxy group or aryl group, Rd is hydrogen or a methyl group and n is an integer of 0 to 3.

Examples of the monomers capable of forming the structural unit (A1) represented by the formula (1) include monomers represented by the following formula (1a)

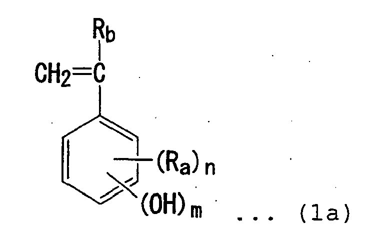

wherein Ra is an alkyl group having 1 to 4 carbon atoms, alkoxy group or aryl group, Rb is hydrogen or a methyl group, n is an integer of 0 to 3 and m is an integer of 1 to 3.
Specific examples of the monomers include aromatic vinyl compounds having a phenolic hydroxyl group such as p-hydroxystyrene, m-hydroxystyrene, o-hydroxystyrene, p-isopropenyl phenol, m-isopropenyl phenol and o-isopropenyl phenol. Of these, it is preferred to use p-hydroxystyrene and p-isopropenyl phenol.

These monomers may be used individually or in combination with two or more.
The structural unit represented by the formula (1) can be formed by performing the copolymerization using the monomer in which the hydroxyl group is protected with t-butyl group or acetyl group, and converting the resulting structural unit into a hydroxystyrene structural unit by a known method, for example, deprotection in the presence of an acid catalyst.

Examples of the monomers capable of forming the structural unit (A2) represented by the formula (2) include monomers represented by the following formula (2a).

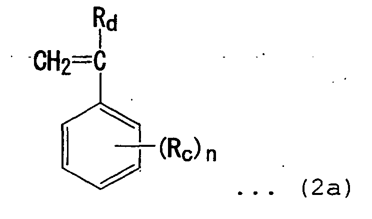

wherein Rc is an alkyl group having 1 to 4 carbon atoms, alkoxy group or aryl group, Rd is hydrogen or a methyl group and n is an integer of 0 to 3.

Examples of the monomers include aromatic vinyl compounds such as styrene, α-methylstyrene, o-methylstyrene, m-methylstyrene, p-methylstyrene, o-methoxystyrene, m-methoxystyrene and p-methoxystyrene. Of these, styrene and p-methoxystyrene are preferred, and styrene is particularly preferred.

These monomers may be used individually or in combination with two or more.
The copolymer (A) is a copolymer of the monomer capable of forming the structural unit (A1) and the monomer capable of forming the structural unit (A2). In essence, it preferably consists only of the structural unit (A1) and the structural unit (A2), but other monomers may be copolymerized. In the copolymer (A), the amount of structural units formed from other monomers is preferably not more than 100 parts by weight, more preferably not more than 50 parts by weight, particularly preferably not more than 25 parts by weight based on 100 parts by weight of the total of the structural units (A1) and (A2).

Examples of the other monomers include compounds having an alicyclic skeleton, unsaturated carboxylic acids and acid anhydrides thereof, esters of the unsaturated carboxylic acids, unsaturated nitriles, unsaturated amides, unsaturated imides and unsaturated alcohols.
Specific examples may include unsaturated carboxylic acids and acid anhydrides thereof such as (meth) acrylic acid, maleic acid, fumaric acid, crotonic acid, mesaconic acid, citraconic acid, itaconic acid, maleic anhydride and citraconic anhydride;
esters of the unsaturated carboxylic acids such as methyl ester, ethyl ester, n-propyl ester, i-propyl ester, n-butyl ester, i-butyl ester, sec-butyl ester, t-butyl ester, n-amyl ester, n-hexyl ester, cyclohexyl ester, 2-hydroxyethyl ester, 2-hydroxypropyl ester, 3-hydroxypropyl ester, 2,2-dimethyl-3-hydroxypropyl ester, benzyl ester, isobornyl ester, tricyclodecanyl ester and 1-admantyl ester;
unsaturated nitriles such as (meth)acrylonitrile, maleinitrile, fumaronitrile, mesaconitrile, citraconitrile and itaconitrile;
unsaturated amides such as (meth)acrylamide, crotonamide, maleinamide, fumaramide, mesaconamide, citraconamide and itaconamide;
unsaturated imides such as maleimide, N-phenyl maleimide and N-cyclohexyl maleimide;
compounds having an alicyclic skeleton such as bicyclo[2.2.1]hepto-2-ene(norbornene), tetracyclo[4.4.0.1^{2,5}1.^{7,10}]dodeca-3-ene, cyclobutene, cyclopentene, cyclooctene, dicyclopentadiene and tricyclo[5.2.1.0^{2,6}]decene;
unsaturated alcohols such as (meth)allylalcohol;
N-vinyl aniline; vinyl pyridines; N-vinyl-E-caprolactam; N-vinyl pyrrolidone; N-vinyl imidazole and N-vinyl carbazole.

These monomers may be used individually or in combination with two or more.
In the copolymer (A), the amount of the structural unit (A1) represented by the formula (1) is from 10 to 99 mol%, preferably 20 to 97 mol%, more preferably 30 to 95 mol%, and the amount of the structural unit (A2) represented by the formula (2) is from 90 to 1 mol%, preferably 80 to 3 mol%, more preferably 70 to 5 mol,%, provided that the amount of total structural units of the copolymer (A) is 100 mol%. When the amounts of the structural units (A1) and (A2) are out of the above ranges, the patterning properties are occasionally lowered and the properties of cured products such as thermal shock properties and the like are occasionally lowered.

When the copolymer (A) comprises the above structural units and the amounts of the structural units are in the above ranges, it is possible to form cured products having excellent various properties such as resolution, electrical insulating properties, thermal shock properties and adhesion, with the electrical insulating properties and thermal shock properties being particularly improved.
Although the molecular weight of the copolymer (A) is not particularly limited, the copolymer (A) has a weight average molecular weight (Mw), as measured by gel permeation chromatography (GPC) using polystyrene standards, of not more than 200, 000, preferably about 2, 000 to 100, 000. Furthermore, it preferably has a ratio (Mw/Mn) of weight average molecular weight (Mw) to number average molecular weight (Mn) of from 1.0 to 10.0, more preferably 1.0 to 8.0. When the Mw is less than 2,000, the properties of cured products such as heat resistance or elongation are lowered, while when it is over 200,000, the compatibility with the other components is lowered or the patterning properties are occasionally lowered. When the ratio Mw/Mn is over the above upper limit, the heat resistance of cured products is occasionally lowered, and the compatibility with the other components and the patterning properties are also lowered occasionally. The values of Mn and Mw are measured using GPC columns manufactured by Tosoh Co. (G2000HXL: 2 columns, G3000HXL: 1 column) under analysis conditions where the flow rate is 1.0 ml/min, the elution solvent is tetrahydrofuran and the column temperature is 40°C, using a mono-dispersed polystyrene as a standard substance by a differential refractometer.

In the copolymer (A), the sequence of the structural unit (A1) of the formula (1), the structural unit (A2) of the formula (2) and the structural units formed from the other monomers is not particularly limited. The copolymer (A) may be any of a random copolymer and a block copolymer.
The copolymer (A) is obtainable by polymerizing the monomer capable of forming the structural unit (A1) of the formula (1) or a compound prepared by protecting the hydroxyl group in the monomer, together with the monomer capable of forming the structural unit (A2) of the formula (2) and the other monomers in the presence of an initiator in a solvent. Although the polymerization method is not particularly limited, radical polymerization or anionic polymerization may be carried out in order to prepare the copolymer having the above molecular weight.

In general, the monomer capable of forming the structural unit of the formula (1) has a protected hydroxyl group. After the polymerization, the monomer having the protected hydroxyl group is converted into a phenolic hydroxyl group-containing structural unit by deprotection in a solvent in the presence of an acid catalyst such as hydrochloric acid or sulfuric acid at a temperature of 50 to 150°C for 1 to 30 hours.
When the alkali solubility of the copolymer (A) is insufficient, a phenol ring-containing compound other than the copolymer (A) (hereinafter referred to as "phenolic compound (a)") may be used in combination. Examples of the phenolic compound (a) include resins having a phenolic hydroxyl group (hereinafter referred to as "phenolic resins") and low molecular phenolic compounds other than the copolymer (A).

Specific examples of the phenolic resins include phenol/formaldehyde condensed novolak resin, cresol/formaldehyde condensed novolak resin, phenol naphthol/formaldehyde condensed novolak resin and hydroxystyrene homopolymer.
Specific examples of the low molecular phenolic compounds include 4,4'-dihydroxydiphenyl methane, 4,4'-dihydroxydiphenyl ether, tris(4-hydroxyphenyl)methane, 1,1-bis(4-hydroxyphenyl)-1-phenylethane, tris(4-hydroxyphenyl)ethane, 1,3-bis[1-(4-hydroxyphenyl)-1-methylethyl]benzene, 1,4-bis[1-(4-hydroxyphenyl)-1-methylethyl]benzene, 4,6-bis[1-(4-hydroxyphenyl)-1-methylethyl]-1,3-dihydroxy benzene, l,l-bis(4-hydroxyphenyl)-l-[4-{l-(4-hydroxyphenyl)-1-methylethyl}phenyl]ethane and 1,1,2,2-tetra(4-hydroxyphenyl)ethane.

The phenolic resin and the low molecular phenolic compound may be used simultaneously, but it is general to use either of them.
These phenolic compounds (a) may be blended in an amount such that the composition exhibits sufficient alkali solubility. Specifically, the phenolic compounds (a) can be used in an amount of preferably from 1 to 200 parts by weight, more preferably 1 to 150 parts by weight, furthermore preferably 1 to 100 parts by weight based on 100 parts by weight of the copolymer (A).

The composition of the present invention usually has a total amount of the copolymer (A) and the phenolic compound (a) in the range of from 40 to 95 parts by weight, preferably 50 to 80 parts by weight based on 100 parts by weight of the composition excluding the solvent (D).

### (B) Quinone diazide group-containing compound

The quinone diazide group-containing compound used in the present invention (hereinafter referred to as "quinone diazide compound (B) ") is an ester compound of a compound having at least one phenolic hydroxyl group and 1,2-naphtoquinone diazide-4-sulphonic acid or 1,2-naphtoquinone diazide-5-sulphonic acid. Examples of the compound having at least one phenolic hydroxyl group, which are not particularly limited, are preferably compounds having the following formulas.

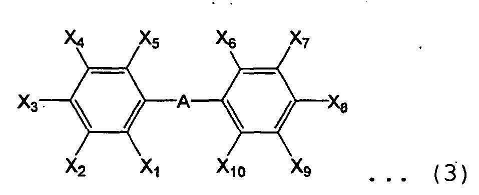

In the formula (3), X₁ to X₁₀ may be the same or different from each other and are each hydrogen, an alkyl group of 1 to 4 carbon atoms, alkoxy group of 1 to 4 carbon atoms or a hydroxyl group. At least one of X₁ to X₅ is a hydroxyl group. Furthermore, A is a single bond, O, S, CH₂, C(CH₃)₂, C(CF₃)₂, C=O or SO₂.

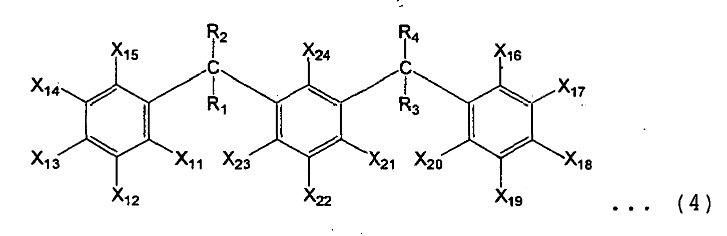

In the formula (4), X₁₁ to X₂₄ may be the same or different from each other and are the same as X₁ to X₁₀. At least one of X₁₁ to X₁₅ is a hydroxyl group. Furthermore, R₁ to R₄ are each hydrogen or an alkyl group of 1 to 4 carbon atoms.

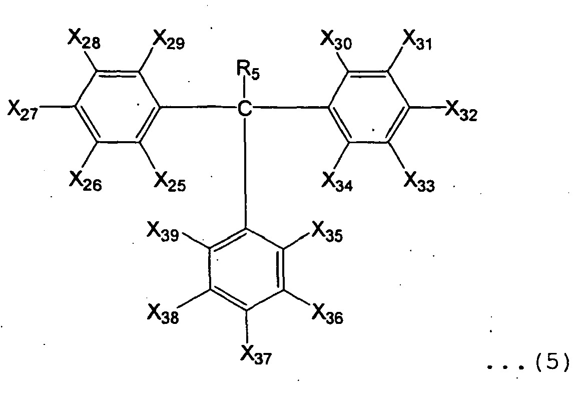

In the formula (5) , X₂₅ to X₃₉ may be the same or different from each other and are the same as X₁ to X₁₀. At least one of X₂₅ to X₂₉ and at least one of X₃₀ to X₃₄ are each a hydroxyl group. Furthermore, R₅ is hydrogen or an alkyl group of 1 to 4 carbon atoms.

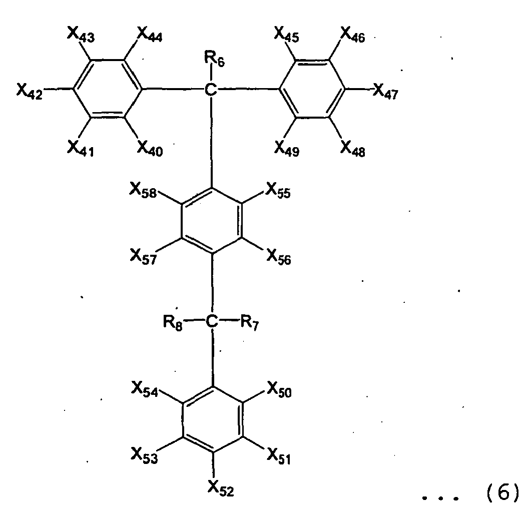

In the formula (6), X₄₀ to X₅₈ may be the same or different from each other and are the same as X₁ to X₁₀. At least one of X₄₀ to X₄₄, at least one of X₄₅ to X₄₉ and at least one of X₅₀ to X₅₄ are each a hydroxyl group. Furthermore, R₆ to R₈ are each hydrogen or an alkyl group of 1 to 4 carbon atoms.

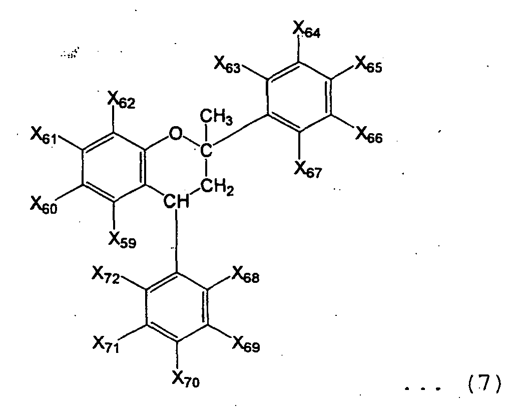

In the formula (7), X₅₉ to X₇₂ may be the same or different from each other and are the same as X₁ to X₁₀. At least one of X₅₉ to X₆₂ and at least one of X₆₃ to X₆₇ are each a hydroxyl group.
Examples of the quinone diazide compound (B) include ester compounds formed between 1,2-naphthoquinone diazide-4-sulfonic acid or 1,2-naphthoquinone diazide-5-sulfonic acid and 4,4'-dihydroxy diphenylmethane, 4,4'-dihydroxy diphenylether, 2,3,4-trihydroxybenzophenone, 2,3,4,4'-tetrahydroxybenzophenone, 2,3,4,2',4'-pentahydroxy benzophenone, tris(4-hydroxyphenyl)methane, tris(4-hydroxyphenyl)ethane, 1,1-bis(4-hydroxyphenyl)-1-phenylethane, 1,3-bis[1-(4-hydroxyphenyl)-1-methylethyl]benzene, 1,4-bis[1-(4-hydroxyphenyl)-1-methylethyl]benzene, 4,6-bis[1-(4-hydroxyphenyl)-1-methylethyl]-1,3-dihydroxy benzene or 1,1-bis(4-hydroxyphenyl)-1-[4-{1-(4-hydroxyphenyl)-1-methy lethyl}phenyl]ethane.

In the composition of the present invention, the quinone diazide compound (B) is preferably used in an amount of from 10 to 50 parts by weight, more preferably 15 to 30 parts by weight based on 100 parts by weight of the total of the copolymer (A) and the phenolic compound (a). When the amount is less than 10 parts by weight, unexposed regions of the film are unfavorably dissolved or the film is often not patterned with fidelity to a mask pattern. When the amount is over 50 parts by weight, the pattern shape is deteriorated or foaming is occasionally induced at the time of curing.

### (C) Crosslinking agent

At least one compound (C) is selected from the group consisting of (C1) 1,2-benzene dimethanol, 1,3-benzene dimethanol, 1,4-benzene dimethanol, 2,6-bis(hydroxymethyl)-p-cresol, 2,6-bis(hydroxymethyl)-4-methylphenol, 5-[1,1-dimethyl-ethyl]2-hydroxy-1,3-benzene dimethanol, 2-hydroxy-1,3,5-benzene trimethanol, 2,6-dimethoxymethyl-4-methylphenol, 2,6-dimethoxymethyl-4-(1,1-dimethylethyl)phenol, 3,3'-methylene bis(2-hydroxy-5-methyl-benzene methanol), 4,4'-(1-methyl ethylidene) bis(2-methyl-6-methoxymethyl phenol), 4,4'-(1-phenyl ethylidene)bis(2-hydroxyethoxy phenol), 3,3',5,5'-tetramethylol-2,2-bis(4-hydroxyphenyl propane), 3,3',5,5'-tetramethoxymethyl-2,2-bis(4-hydroxyphenyl propane), 1,2,4,5-tetramethylol benzene and 1,2,4,5-tetramethoxy methylbenzene, the aromatic aldehyde compound (C2), the aliphatic aldehyde compound (C3), the alkyl-etherified amino group-containing compound (C4) and the epoxy group-containing compound (C5) (hereinafter referred to as "crosslinking agent (C)"). It acts as a crosslinking component which reacts with the copolymer (A) and the phenolic compound (a).

The aromatic aldehyde compound (C2) and the aliphatic aldehyde compound (C3) are not particularly limited as long as they contain an aldehyde group in the molecule. Examples thereof may include formaldehyde, benzaldehyde, acetaldehyde, propylaldehyde, phenylacetaldehyde, α-phenylpropylaldehyde, β-phenylpropylaldehyde, o-hydroxybenzaldehyde, m-hydroxybenzaldehyde, p-hydroxybenzaldehyde, o-methylbenzaldehyde, m-methylbenzaldehyde, p-methylbenzaldehyde, furfural, glyoxal, glutaraldehyde, terephthalaldehyde and isophthalaldehyde.

The alkyl-etherified amino group-containing compound (C4) (hereinafter referred to as "alkyl-etherified amino group-containing compound (C4)") has at least two alkyl-etherified amino groups in the molecule. This alkyl-etherified amino group is represented by, for example, the following formula.

-NHR^{e}-O-R^{f}

In the formula, R^{e} is an alkylene group (bivalent hydrocarbon group) and R^{f} is an alkyl group.
Examples of the alkyl-etherified amino group-containing compound (C4) may include compounds obtainable by alkyl-etherifying all or a part (at least two) of active methylol groups (CH₂OH groups) in a nitrogen compound, such as (poly)methylolated melamine, (poly)methylolated glycoluril, (poly)methylolated benzoguanamine and (poly)methylolated urea. The alkyl groups for alkyl-etherification may be the same or different and are each a methyl group, ethyl group or butyl group. The methylol groups without alkyl-etherification may be self-condensed in the molecule or such methylol groups in two molecules may be condensed, to form an oligomer component. Examples thereof include hexamethoxymethylated melamine, hexabutoxymethylated melamine, tetramethoxymethylated glycoluril and tetrabutoxymethylated glycoluril.

The epoxy group-containing compound (C5) (hereinafter referred to as "epoxy group-containing compound (C5)") is not particularly limited as long as it contains an epoxy group in the molecule. Examples thereof include phenol novolak epoxy resin, cresol novolak epoxy resin, bisphenol epoxy resin, trisphenol epoxy resin, tetraphenol epoxy resin, phenol-xylylene epoxy resin, naphthol-xylylene epoxy resin, phenol-naphthol epoxy resin, phenol-dicyclopentadiene epoxy resin, alicyclic epoxy resin and aliphatic epoxy resin.

These crosslinking agents (C) may be used singly or in combination with two or more.
In the composition of the present invention, these crosslinking agents (C) are preferably used in an amount of 1 to 100 parts by weight, more preferably 2 to 70 parts by weight, based on 100 parts by weight of the total of the copolymer (A) and the phenolic compound (a). When the amount of the crosslinking agents is less than 1 part by weight, the resulting cured film occasionally has lowered chemical resistance. When it is over 100 parts by weight, the resolution is occasionally lowered.

When the curing properties of the composition of the present invention are insufficient, a crosslinking assistant may be used in combination. Examples of the crosslinking assistant include compounds having a glycidyl ether group, glycidyl ester group, glycidyl amino group, benzyloxy methyl group, dimethyl aminomethyl group, diethyl aminomethyl group, dimethylol aminomethyl group, diethylol aminomethyl group, morpholino methyl group, acetoxymethyl group, benzoyloxy methyl group, acetyl group, vinyl group or isopropenyl group.

These crosslinking assistants can be added in an amount such that the composition of the present invention can exhibit sufficient curing properties. Specifically, it can be blended in an amount of 0 to 100 parts by weight based on 100 parts by weight of the crosslinking agent (C).

### (D) Solvent

The solvent (D) used in the present invention is added in order to improve the handling properties of the resin composition or to regulate the viscosity and storage stability. Examples of the solvent (D), which are not particularly limited, include ethylene glycol monoalkylether acetates such as ethylene glycol monomethylether acetate and ethylene glycol monoethylether acetate;
propylene glycol monoalkylethers such as propylene glycol monomethylether, propylene glycol monoethylether, propylene glycol monopropylether and propylene glycol monobutylether;
propylene glycol dialkylethers such as propylene glycol dimethylether, propylene glycol diethylether, propylene glycol dipropyl ether and propylene glycol dibutylether;
propylene glycol monoalkylether acetates such as propylene glycol monomethylether acetate, propylene glycol monoethylether acetate, propylene glycol monopropylether acetate and propylene glycol monobutylether acetate;
cellosolves such as ethyl cellosolve and butyl cellosolve;
carbitols such as butyl carbitol;
lactic acid esters such as methyl lactate, ethyl lactate, n-propyl lactate and isopropyl lactate;
aliphatic carboxylic acid esters such as ethyl acetate, n-propyl acetate, isopropyl acetate, n-butyl acetate, isobutyl acetate, n-amyl acetate, isoamyl acetate, isopropyl propionate, n-butyl propionate and isobutyl propionate;
other esters such as methyl 3-methoxypropionate, ethyl 3-methoxypropionate, methyl 3-ethoxypropionate, ethyl 3-ethoxypropionate, methyl pyruvate and ethyl pyruvate;
aromatic hydrocarbons such as toluene and xylene;
ketones such as 2-heptanone, 3-heptanone, 4-heptanone and cyclohexanone;
amides such as N-dimethyl formamide, N-methyl acetamide, N,N-dimethyl acetamide and N-methylpyrrolidone; and
lactones such as γ-butyrolactone. These organic solvents may be used singly or in combination with two or more.

The solvent (D) is usually used in an amount of from 40 to 900 parts by weight, preferably 60 to 400 parts by weight based on 100 parts by weight of the total of the components other than the solution in the composition.

### (E) Adhesion assistant

The adhesion assistant (E) is silane coupling agent, for example, a silane coupling agent having a reactive substituent such as carboxylic group, methacryloyl group, isocyanate group or epoxy group. Specific trimethoxysilylbenzoic acid, γ-methacryloxy propyl trimethoxy silane, vinyl triacetoxy silane, vinyltrimethoxy silane, γ-isocyanate propyl triethoxy silane, γ-glycidoxy propyl trimethoxy silane, β-(3,4-epoxy cyclohexyl)ethyltrimethoxy silane or 1,3,5-N-tris(trimethoxysilyl propyl)isocynanurate.

The adhesion assistant (E) is usually used in an amount of from 0.5 to 10 parts by weight, preferably 0.5 to 8.0 parts by weight based on 100 parts by weight of the total of the copolymer (A) and the phenolic compound (a).

### (F) Crosslinked fine particles

The crosslinked fine particles optionally used in the present invention (hereinafter referred to as "crosslinked fine particles (F)") are not particularly limited as long as they are composed of a polymer having a glass transition temperature (Tg) of not higher than 100°C. The polymer is preferably a copolymer of a crosslinkable monomer having at least two unsaturated polymerizable groups (hereinafter referred to as "crosslinkable monomer") and at least one other monomer selected such that at least one Tg of the crosslinked fine particles (F) is not higher than 0°C (hereinafter referred to as "other monomer (f)"). Preferred examples of the other monomer (f) include monomers having a functional group except for a polymerizable group, such as carboxyl group, epoxy group, amino group, isocyanate group or hydroxyl group.

To determine Tg of the crosslinked fine particles (F) in the present invention, the crosslinked fine particles are coagulated in a dispersion thereof and are dried, and the particles are analyzed using DSC SSC/5200H of Seiko Instruments at a temperature of from -100°C to 150°C at a temperature-elevating rate of 10°C/min.
Examples of the crosslinkable monomer include compounds having plural polymerizable unsaturated groups such as divinyl benzene, diallyl phthalate, ethylene glycol di(meth)acrylate, propylene glycol di(meth)acrylate, trimethylol propane tri(meth)acrylate, pentaerythritol tri(meth)acrylate, polyethylene glycol di (meth) acrylate and polypropylene glycol di(meth)acrylate. Among them, divinyl benzene is preferred.

The proportion of the crosslinkable monomer constituting the crosslinked fine particles (F) is preferably from 0.1 to 20 wt%, more preferably 0.5 to 10 wt% based on 100 wt% of all the monomers.
Examples of the other monomer (f) include:
diene compounds such as butadiene, isoprene, dimethyl butadiene, chloroprene and 1,3-pentadiene;
unsaturated nitrile compounds such as (meth)acrylonitrile, α-chloroacrylonitrle α-chloromethylacrylonitrile, α-methoxy acrylonitrile, α-ethoxy acrylonitrile, nitrile crotonate, nitrile cinnamate, dinitrile itaconate, dinitrile maleate and dinitrile fumarate;
unsaturated amides such as (meth)acrylamide, N,N'-methylene bis(meth)acrylamide, N,N'-ethylene bis(meth)acrylamide, N,N'-hexamethylene bis (meth) acrylamide, N-hydroxymethyl (meth)acrylamide, N-(2-hydroxyethyl)(meth)acrylamide, N,N-bis(2-hydroxyethyl)(meth)acrylamide, crotonic acid amide and cinnamic acid amide;
(meth) acrylic acid esters such as methyl (meth) acrylate, ethyl (meth)acrylate, propyl (meth)acrylate, butyl (meth)acrylate, hexyl (meth)acrylate, lauryl (meth)acrylate, polyethylene glycol (meth)acrylate and polypropylene glycol (meth)acrylate;
aromatic vinyl compounds such as styrene, α-methyl styrene, o-methoxystyrene, p-hydroxystyrene and p-isopropenyl phenol;
epoxy group-containing unsaturated compounds such as epoxy (meth)acrylates obtained by reaction of bisphenol A diglycidyl ether, a glycol diglycidyl ether or the like with (meth) acrylic acid, a hydroxyalkyl (meth) acrylate or the like; urethane (meth)acrylates obtained by reaction of a hydroxyalkyl (meth)acrylate with a polyisocyanate; glycidyl (meth)acrylate and (meth)allyl glycidyl ether;
unsaturated acid compounds such as (meth)acrylic acid, itaconic acid, β-(meth)acryloxyethyl succinate, β-(meth)acryloxyethyl maleate, β-(meth)acryloxyethyl phthalate and β-(meth)acryloxyethyl hexahydrophthalate;
amino group-containing unsaturated compounds such as dimethyl amino(meth)acrylate and diethyl amino(meth)acrylate;
amide group-containing unsaturated compounds such as (meth)acrylamide and dimethyl(meth)acrylamide; and
hydroxyl group-containing unsaturated compounds such as hydroxyethyl (meth)acrylate, hydroxypropyl (meth)acrylate and hydroxybutyl(meth)acrylate.

Of these, it is preferred to use butadiene, isoprene, (meth)acrylonitrile, (meth) acrylic acid alkyl esters, styrene, p-hydroxystyrene, p-isopropenyl phenol, glycidyl (meth)acrylate, (meth)acrylic acid and hydroxyalkyl (meth)acrylates.
The proportion of the other monomers (f) constituting the crosslinked fine particles (F) is preferably from 80 to 99.9 wt%, more preferably 90.0 to 99.5 wt% based on 100 wt% of all the monomers used in the copolymerization.

It is preferred to use, as the other monomers (f), at least one diene compound, for example, butadiene. The diene compound is used in an amount of from 20 to 80% by weight, preferably 30 to 70% by weight based on 100% by weight of all the monomers used in the copolymerization. When the copolymer includes the diene compounds such as butadiene as the other monomers (f) in the above amount based on all the monomers, the crosslinked fine particles (F) are rubbery soft fine particles and can prevent the resulting cured film from cracking (breaking) and thereby the cured film shows excellent durability. Furthermore, the combined use of styrene and butadiene as the other monomers (f) enables the resulting cured film to have a low permittivity.

The crosslinked fine particles (F) usually have an average particle diameter of from 30 to 500 nm, preferably 40 to 200 nm, furthermore preferably 50 to 120 nm. The method of controlling the particle diameters of the crosslinked fine particles is not particularly limited. When the crosslinked fine particles are synthesized by emulsion polymerization, the particle diameters may be controlled by regulating the number of micelles in the emulsion polymerization by the amount of an emulsifying agent used.

In the present invention, the average particle diameter of the crosslinked fine particles (F) is a value determined by diluting a dispersion of the crosslinked fine particles through an ordinary method and measuring the diameters using a particle size distribution measuring apparatus by light scattering LPA-3000 manufactured by Otsuka Electronics Co. Ltd.
The amount of the crosslinked fine particles (F) is preferably 0.1 to 50 parts by weight, preferably 1 to 20 parts by weight based on 100 parts by weight of the total amount of the copolymer (A) and the phenolic compound (a). When the amount is less than 0.1 part by weight, the thermal shock properties of the resulting cured film are occasionally lowered, while when it is over 50 parts by weight, the heat resistance is lowered or the compatibility (dispersibility) with the other components is lowered occasionally.

### Other additives;

The positive photosensitive resin composition of the present invention may contain other additives such as a sensitizer, leveling agent and acid generating agent within the limit of not missing the properties of the composition of the present invention.

### (Process for preparation of Composition)

The process for preparation of the positive photosensitive resin composition of the present invention is not particularly limited, and a usual preparation process can be employed. Furthermore, the composition can be also prepared by feeding the components into a sample bottle followed by sealing, and mixing the components on a wave rotor.

### [Cured product]

The positive photosensitive insulating resin composition according to the present invention contains the copolymer (A), the quinone diazide compound (B), the crosslinking agent (C), the solvent (D) and the adhesion assistant (E), and optionally the phenolic compound (a), the crosslinked fine particles (F), the crosslinking assistant and other additives. The cured products prepared from the composition have excellent resolution, thermal shock resistance, adhesion and electrical insulating properties. Accordingly, the positive photosensitive insulating resin composition of the present invention can be suitably used as materials for surface protective films or interlaminar insulating films for semiconductor elements.

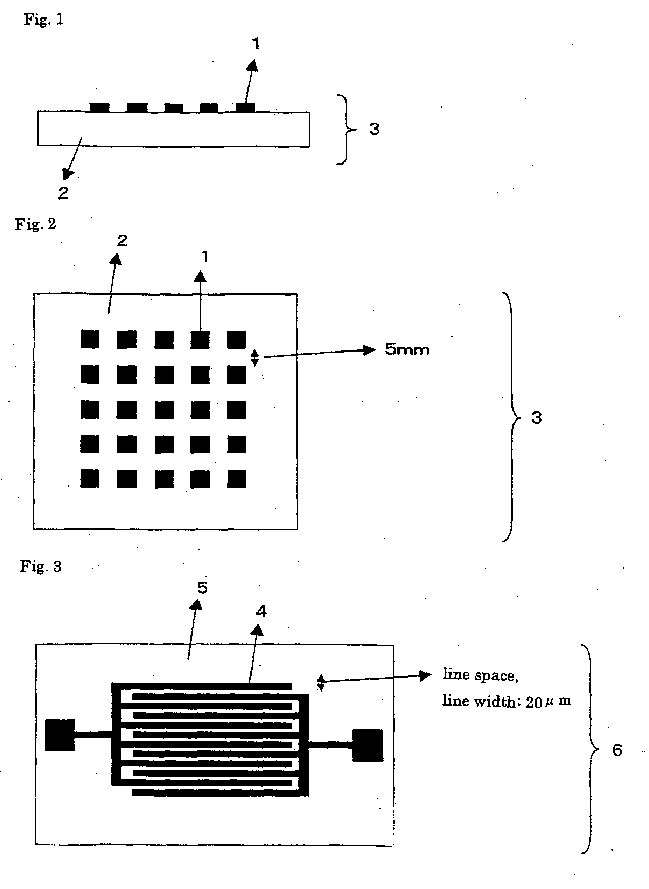

The cured products according to the present invention have excellent electrical insulating properties, and preferably has a resistant value, as determined after a migration test, of not less than 10⁸Ω, more preferably not less than 10⁹Ω, furthermore preferably not less than 10¹⁰Ω. The migration test in the present invention is carried out in the following manner.
The resin composition is applied on an evaluation substrate as shown in Fig. 3, and heated at 110°C for 3 minutes using a hot plate to form a resin coating film having a thickness on a copper foil of 10 µm. Thereafter, the resin coating film is cured by heating at 190°C for 1 hour using a convection type oven, to prepare a cured film. This base material is introduced into a migration evaluation system (manufactured by ESPEC CORP. , AEI, EHS-221MD) and treated at a temperature of 121°C, a humidity of 85%, a pressure of 1.2 atm and an applied voltage of 5V for 200 hours and thereafter the resistance value (Ω) of the test base material is measured.

The cured products of the present invention have excellent thermal shock resistance. Specifically, the cured product preferably undergoes not less than 1000 cycles, more preferably not less than 1500 cycles, still more preferably not less than 2000 cycles without being cracked in a thermal shock test wherein 1 cycle consists of cooling at -65°C for 30 min and heating at 150°C for 30 min. The thermal shock test according to the present invention is carried out specifically in the following manner.

The resin composition is applied on an evaluation substrate as shown in Figs. 1 and 2, and heated at 110°C for 3 minutes using a hot plate to prepare a resin coating film having a thickness on a copper foil of 10 µm. The resin coating film is heated at 190°C for 1 hour using a convection type oven to prepare a cured product. The resulting substrate is subjected to a resistance test by means of a thermal shock testing apparatus (TSA-40L manufactured by ESPEC CORP.) wherein 1 cycle consists of cooling at -65°C for 30 min and heating at 150°C for 30 min. Defects such as cracks are inspected every 100 cycles until they occur on the cured film. Therefore, the larger the cycle number is until defects such as cracks are caused on the cured product, the more excellent the thermal shock properties of the cured product are.

The cured product of the present invention may be produced as follows. First, the positive photosensitive insulating resin composition of the present invention is applied on a support (resin clad copper foil, copper clad laminate, or metal-sputtered silicon wafer or alumina substrate), and is dried to evaporate the solvent and the like. The resultant coating film is exposed through a desired mask pattern and the exposed part of the film is dissolved and removed with an alkali developing solution to produce a desired pattern. Furthermore, after the development, the film is treated with heat to obtain insulation film properties. The cured film is thus prepared.

The methods of applying the resin composition to the support include a dipping method, spray method, bar coat method, roll coat method and spin coat method. The thickness of the resin composition may be appropriately controlled by selecting the coating means or regulating the concentration of the solid components in the composition solution or the viscosity of the composition solution.
Examples of the radiations used in exposure may include ultraviolet ray radiations from a low-pressure mercury lamp, high-pressure mercury lamp, metal halide lamp, g-line stepper and i-line stepper, and electron beams and leaser beams. The exposure quantity is appropriately selected depending on the light source or resin film thickness. In the case of ultraviolet ray irradiation using a high-pressure mercury lamp, the exposure quantity is about from 1,000 to 50,000 J/m² with the resin film thickness of from 10 to 50 µm.

After the exposure, the coating film is developed by an alkali developing solution and thereby the exposed part of the coating film is dissolved and removed. Consequently, a desired pattern is formed. Examples of the development method may include a shower developing method, spray-developing method, immersion-developing method and puddle developing method. The developing is usually carried out at a temperature of from 20 to 40°C for about 1 to 10 min. Examples of the alkali developing solution may include approximately 1 to 10% by weight aqueous solutions of alkaline compounds such as sodium hydroxide, potassium hydroxide, aqueous ammonia, tetramethyl ammonium hydroxide and choline. The alkali aqueous solution may contain an appropriate amount of a water-soluble organic solvent such as methanol or ethanol, or a surface-active agent. The coating film is developed with the alkali developing solution, and thereafter washed with water and dried.

Moreover, after the development, the coating film is heated and thereby sufficiently cured to exhibit satisfactory properties as insulating film. The curing conditions are not particularly limited. Depending on the uses of the cured product, the coating film can be cured by heating at a temperature of 50 to 200°C for about 30 minutes to 10 hours.
To make sure that the patterned coating film is sufficiently cured and is not deformed, the above heat treatment can be carried out in two or more steps. For example, the patterned coating film can be cured by heating at a temperature of from 50 to 120°C for about 5 minutes to 2 hours in the first step and can be further cured by heating at a temperature of from 80 to 200°C for about 10 minutes to 10 hours in the second step.

Provided that the curing conditions are as described above, the heating apparatus may be a hot plate, oven or infrared furnace.

### [Example]

The present invention is described in more detail below with reference to the following examples, but it is not limited by the examples. In the following examples and comparative examples, the term "part" is used as "part by weight" unless otherwise indicated.

The properties of cured products were evaluated in the following manners.

### Resolution:

The resin composition was spin coated on a 6-inch silicon wafer and heated at 110°C for 3 minutes using a hot plate to prepare a uniform coating film having a thickness of 10 µm. Thereafter, using an aligner (Suss Microtec Co. , Ltd., MA-100), the coating film was exposed to an ultraviolet ray from a high-pressure mercury lamp through a pattern mask in an exposure quantity of 8,000 J/m² at a wavelength of 350 nm. Subsequently, the coating film was developed by being immersed in a 2.38% by weight aqueous tetramethyl ammonium hydroxide solution at 23°C for 90 sec. The minimum dimension in the resulting pattern was taken as the resolution.

### Adhesion:

The resin composition was applied on a SiO₂-sputtered silicon wafer and heated at 110°C for 3 minutes using a hot plate to prepare a uniform resin coating film having a thickness of 10 µm. Thereafter, the resin coating film was cured by heating at 190°C for 1 hour using a convection type oven, to prepare a cured film. This cured film was treated by a pressure cooker testing apparatus (manufactured by ESPEC Corp., EHS-221MD) at a temperature of 121°C, a humidity of 100%, and a pressure of 2.1 atm for 168 hours. Before and after the test, a cross cut test (cross cut tape method) was carried out in accordance with JIS K 5400 to evaluate adhesion.

### Thermal shock properties:

The resin composition was applied on a thermal shock-testing base material 3 that had a patterned copper foil 1 on a substrate 2 as shown in Figs. 1 and 2. The resin composition was heated at 110°C for 3 minutes using a hot plate. Consequently, the base material had a resin coating film with a thickness on the copper foil 1 of 10 µm. Then, the resin coating film was cured by heating at 190°C for 1 hour using a convection type oven, to prepare a cured film. The resulting base material was subjected to a resistance test wherein 1 cycle consisted of cooling at -65°C for 30 min and heating at 150°C for 30 min, using a thermal shock testing apparatus (manufactured by ESPEC Corp., TSA-40L). Defects such as cracks were inspected every 100 cycles until they occurred on the cured film.

### Electrical insulating properties (Migration test):

The resin composition was applied on a thermal shock-testing base material 6 that had a patterned copper foil 4 on a substrate 5 as shown in Fig. 3. The resin composition was heated at 110°C for 3 minutes using a hot plate. Consequently, the base material had a resin coating film with a thickness on the copper foil 4 of 10 µm. Then, the resin coating film was cured by heating at 190°C for 1 hour using a convection type oven, to prepare a cured film. The resulting base material was introduced into a migration evaluating system (manufactured by ESPEC Corp., AEI, EHS-221MD) and treated at a temperature of 121°C, a humidity of 85%, a pressure of 1.2 atm and an applied voltage of 5 V for 200 hours. Thereafter, the resistance value (Ω) of the test base material was measured to check the insulating properties.

### Synthesis Example 1

### (Synthesis of p-hydroxystyrene/styrene copolymer)

100 Parts by weight of a 80:20 (by mol) mixture of p-t-butoxystyrene and styrene was dissolved in 150 parts by weight of propylene glycol monomethyl ether. These compounds were polymerized using 4 parts by weight of azobisisobutylonitrile for 10 hours in a nitrogen atmosphere while keeping the reaction temperature at 70°C. Thereafter, sulfuric acid was added to the reaction solution, and reaction was performed for 10 hours while keeping the reaction temperature at 90°C. Consequently, p-t-butoxystyrene was deprotected into hydroxystyrene. To the resulting copolymer, ethyl acetate was added, and washing with water was repeated five times to separate and collect the ethyl acetate phase. The solvent was removed and thereby a p-hydroxystyrene/styrene copolymer (hereinafter referred to as "copolymer (A-1)") was prepared.

The molecular weight of the copolymer (A-1) was measured by gel permeation chromatography (GPC), resulting in a weight average molecular weight (Mw) relative to polystyrene standards of 10,000 and a ratio (Mw/Mn) of weight average molecular weight (Mw) to number average molecular weight (Mn) of 3.5. Furthermore, as a result of ¹³C-NMR analysis, the copolymerization molar ratio of p-hydroxystyrene and styrene was 80:20.

### Synthesis Example 2

### (Synthesis of p-hydroxystyrene homopolymer)

The procedure of Synthesis Example 1 was repeated except that 100 parts by weight of p-t-butoxystyrene alone was dissolved in 150 parts by weight of propylene glycol monomethyl ether to prepare a p-hydroxystyrene homopolymer (hereinafter, referred to as "homopolymer (A-2)").

The homopolymer (A-2) had an Mw of 10,000 and Mw/Mn of 3.2.

### Synthesis Example 3

### (Synthesis of p-hydroxystyrene/styrene/hydroxybutyl acrylate copolymer)

The procedure of Synthesis Example 1 was repeated except that 100 parts by weight of a 80:20:10 (by mol) mixture of p-t-butoxystyrene, styrene and hydroxylbutyl acrylate was dissolved in 150 parts by weight of propylene glycol monomethyl ether to prepare a p-hydroxystyrene/styrene/hydroxybutyl acrylate copolymer (hereinafter, referred to as "copolymer (A-3)").

The copolymer (A-3) had an Mw of 10,000, Mw/Mn of 3.5 and a copolymerization molar ratio of p-hydroxystyrene : styrene : hydroxybutyl acrylate of 80:10:10.

### Synthesis Example 4

### (Synthesis of phenolic resin (a-1))

A mixture of m-cresol and p-cresol in a molar ratio of 60:40 was prepared, and formalin was added thereto. The mixture was condensed using an oxalic acid catalyst by an ordinary method to prepare a cresol novolak resin having an Mw of 6,500 (hereinafter, referred to as "phenolic resin (a-1)").

### Synthesis Example 5

### (Synthesis of quinone diazide compound)

One mole of 1,1-bis(4-hydroxyphenyl)-1-[4-[1-(4-hydroxyphenyl)-1-methylethyl]phenyl]ethane and 2.0 moles of 1,2-naphthoquinone diazide-5-sulfonic acid chloride were dissolved in dioxane with stirring to prepare a solution. Then, this solution was placed in a flask and the flask was immersed in a water bath controlled at 30°C. When the temperature of the solution was constant at 30°C, 2.0 moles of triethylamine was slowly dropped to the solution using a dropping funnel in such a way that the solution temperature was not over 35°C. Thereafter, triethylamine hydrochloride deposited was removed by filtration. The filtrate was poured into a large amount of dilute hydrochloric acid. After this procedure, the resultant deposit was collected with filtration and dried day and night in a vacuum dryer controlled at 40°C to prepare a quinone diazide compound (hereinafter referred to as "quinone diazide compound (B-1)").

### Synthesis Example 6

### (Synthesis of quinone diazide compound)

The procedure of Synthesis Example 5 was repeated except that 1 mole of 1,1-bis(4-hydroxyphenyl)-1-phenylethane and 1.5 mole of 1,2-naphthoquinone diazide-5-sulfonic acid were used as raw materials to prepare a quinone diazide compound (hereinafter, referred to as "quinone diazide compound (B-2)").

### Example 1

As shown in Table 1, 100 parts by weight of the polymer (A-1), 20 parts by weight of the quinone diazide compound (B-1), 25 parts by weight of a crosslinking agent (C-1) and 2.5 parts by weight of an adhesion assistant (E-1) were dissolved in 145 parts by weight of a solvent (D-1) to prepare a resin composition. The properties of this composition were measured in accordance with the above evaluation methods. The results are shown in Table 3.

### Examples 2 to 5

In each example, the procedure of Example 1 was repeated to prepare a composition composed of the components as shown in Table 1. The properties of the composition and its cured film were measured in the same manner as that in Example 1. The results are shown in Table 3.

### Comparative Examples 1 to 3

In each comparative example, the procedure of Example 1 was repeated to prepare a composition composed of the components as shown in Table 1. The properties of the composition and its cured film were measured in the same manner as that in Example 1. The results are shown in Table 3.

### Example 6

As shown in Table 2, 100 parts by weight of the polymer (A-1), 20 parts by weight of the quinone diazide compound (B-1), 25 parts by weight of a crosslinking agent (C-3), 10 parts by weight of a crosslinking agent (C-5) and 2.5 parts by weight of an adhesion assistant (E-1) were dissolved in 155 parts by weight of a solvent (D-1) to prepare a resin composition. The properties of this composition were measured in accordance with the above evaluation methods. The results are shown in Table 4.

### Examples 7 to 10

In each example, the procedure of Example 1 was repeated to prepare a composition composed of the components as shown in Table 2. The properties of the composition and its cured film were measured in the same manner as that in Example 1. The results are shown in Table 4.

### Comparative Examples 4 to 7

In each comparative example, the procedure of Example 1 was repeated to prepare a composition composed of the components as shown in Table 2. The properties of the composition and its cured film were measured in the same manner as that in Example 1. The results are shown in Table 4.

**Table 1**

| | Polymer (A) / Phenolic (a) | Quinone diazide compound | Crosslinking agent compound -tant | | | Solvent | Adhesion assis | Additive |
|---|---|---|---|---|---|---|---|---|
| | kind/part | kind/part | kind/part | kind/part | kind/part | kind/part | kind/part | kind/part |
| EX. 1 | A-1; 100 | B-1; 20 C-1; D-1; E-1; | 25 | | | 145 | 2.5 | |
| Ex. 2 | A-1;100 | B-1; 20 | C-1; 15 | C-2; 10 | | D-1; 155 | E-1; 2.5 | F-1; 10 |
| Ex. 3 | A-1/a-1; 80/20 | B-2; 20 | | C-2; 25 | | D-2; 150 | E-1; 2.5 | F-2; 5 |
| Ex. 4 | A-1;100 | B-2; 20 | | C-2; 15 | C-6; 10 | D-2; 150 | E-1; 2.5 | F-1; 5 |
| Ex. 5 | A-3;100 | B-2; 20 | | C-2; 15 | C-6; 10 | D-2; 150 | E-1; 2.5 | F-1; 5 |
| Compar. Ex. 1 | A-2;100 | B-1; 20 | C-1; 25 | | | D-1; 145 | E-1; 2.5 | |
| Compar. Ex. 2 | A-1;100 | B-1; 20 | | | | D-1; 130 | E-1; 2.5 | F-1; 10 |
| Compar. Ex. 3 | A-1;100 | B-1; 20 | C-1; 15 | C-2; 10 | | D-1; 155 | | F-1; 10 |

**Table 2**

| | Polymer (A)/ Phenolic compound (a) | Quinone diazide compound | agent | Crosslinking | Solvent | Adhesion assistant | Additive |
|---|---|---|---|---|---|---|---|
| | kind/part | kind/part | kind/part | kind/part | kind/part | kind/part | kind/part |
| Ex. 6 | A-1;100 | B-1; 20 | C-3; 25 | C-5; 10 | D-1: 155 | E-1; 2.5 | |
| Ex. 7 | A-1;100 | B-1; 20 | C-3; 20 | | D-1; 150 | E-1; 2.5 | F-1; 10 |
| Ex. 8 | A-1/a-1; 80/20 | B-2; 20 | | C-5; 25 | D-2; 150 | E-1; 2.5 | F-2; 5 |
| Ex. 9 | A-1/a-2; 70/30 | B-1; 20 | C-3; 20 | C-6; 5 | D-1; 145 | E-1; 2.5 | |
| Ex. 10 | A-3;100 | B-1; 20 | C-3; 20 | C-6; 5 | D-1; 145 | E-1; 2.5 | |
| Compar. Ex. 4 | A-2;100 | B-1; 20 | C-3; 25 | C-5; 10 | D-1; 155 | E-1; 2.5 | |
| Compar. Ex. 5 | a-1;100 | B-1; 20 | C-3; 25 | | D-1; 155 | E-1; 2.5 | F-1; 10 |
| Compar. Ex. 6 | A-1;100 | B-1; 20 | | | D-1; 120 | E-1; 2.5 | |
| Compar. Ex. 7 | A-1;100 | B-1; 20 | C-3; 25 | C-5; 10 | D-1; 155 | | |

| | | | | | | | |
|---|---|---|---|---|---|---|---|
| Note) The compositions as described in Tables 1 and 2 are as follows. | | | | | | | |

### Polymers:

A-1: copolymer of p-hydroxystyrene and styrene in a molar ratio of 80/20, having a weight average molecular weight (Mw) of 10,000 as determined relative to polystyrene standards
A-2: homopolymer of p-hydroxystyrene having a weight average molecular weight (Mw) of 10,000 as determined relative to polystyrene standards
A-3: copolymer of p-hydroxystyrene, styrene and hydroxybutyl acrylate in a molar ratio of 80/10/10, having a weight average molecular weight (Mw) of 10,000 as determined relative to polystyrene standards

### Phenolic compound:

a-1: cresol novolak resin of m-cresol and p-cresol in a molar ratio of 60/40 (Mw=6,500)

### Quinone diazide compounds:

a-2:1,1,-bis(4-hydroxyphenyl)-1-[4-{1-(4-hydroxyphenyl)-1 methylethyl}phenyl]ethane
B-1: condensed product of 1,1-bis(4-hydroxyphenyl)-1-[4-[1-(4-hydroxyphenyl)-1-methylethyl]phenyl]ethane and 1,2-naphthoquinone diazide-5-sulfonic acid in a molar ratio of 1.0/2.0
B-2: condensed product of 1,1-bis(4-hydroxyphenyl)-1-phenylethane and 1,2-naphthoquinone diazide-5-sulfonic acid in a molar ratio of 1.0/1.5

### Crosslinking agents:

C-1: o-hydroxybenzaldehyde
C-2: 2,6-bis(hydroxymethyl)-p-cresol
C-3: hexamethoxy methyl melamine (manufactured by Mitsui Cytec Co., Trade Name; CYMEL 300)
C-4: tetramethoxy methylglycol uryl (manufactured by Mitsui Cytec Co., Trade Name; CYMEL 1174)
C-5: bisphenol A type epoxy resin (manufactured by Japan Epoxy Resin Co., Trade Name; EP-828)
C-6: propylene glycol diglycidyl ether (manufactured by Kyoei sha Co., Ltd., Trade Name: EPOLITE 70P)

### Solvents:

D-1: ethyl lactate
D-2: 2-heptanone

### Adhesion assistant:

E-1: γ-glycidoxy propyl trimethoxy silane (manufactured by Nippon Unicar Co., Ltd., Trade Name: A-187)

### Crosslinked fine particles:

F-1: butadiene/hydroxybutyl methacrylate/methacrylic acid/divinyl benzene = 60/32/6/2 (wt%), average particle diameter = 65 nm
F-2: butadiene/styrene/hydroxybutyl methacrylate/methacrylic acid/divinyl benzene = 60/20/12/6/2 (wt%), average particle diameter = 65 nm

**Table 3**

| | Resolution (µm) | Adhesion | | Thermal shock test (cycle) | Insulating properties (Ω) |
|---|---|---|---|---|---|
| | | before test | after test | | |
| Ex. 1 | 5 | 100/100 | 100/100 | 2,000 | 1x10¹² |
| Ex. 2 | 5 | 100/100 | 100/100 | 2,000 | 1x10¹² |
| Ex. 3 | 10 | 100/100 | 100/100 | 2,000 | 1x10¹² |
| Ex. 4 | 5 | 100/100 | 100/100 | 2,000 | 1x10¹² |
| Ex. 5 | 5 | 100/100 | 100/100 | 2,000 | 1x10¹² |
| Compar. Ex. 1 | 5 | 100/100 | 100/100 | 2,000 | 1x10⁶ |
| Compar. Ex. 2 | 5 | 10/100 | 0/100 | 100 | 1x10⁶ |
| Compar. Ex. 3 | 5 | 100/100 | 0/100 | 2,000 | 1x10¹² |

**Table 4**

| | Resolution (µm) | Adhesion | | Thermal shock test (cycle) | Insulating properties (Q) |
|---|---|---|---|---|---|
| | | before test | after test | | |
| Ex. 6 | 5 | 100/100 | 100/100 | 2,000 | 1x10¹² |
| Ex. 7 | 5 | 100/100 | 100/100 | 2,000 | 1x10¹² |
| Ex. 8 | 10 | 100/100 | 100/100 | 2,000 | 1x10¹² |
| Ex. 9 | 10 | 100/100 | 100/100 | 2,000 | 1x10¹² |
| Ex. 10 | 10 | 100/100 | 100/100 | 2,000 | 1x10¹² |
| Compar. Ex. 4 | 5 | 100/100 | 100/100 | 2,000 | 1x10⁶ |
| Compar. Ex. 5 | 10 | 80/100 | 60/100 | 300 | 1x10¹² |
| Compar. Ex. 6 | 10 | 20/100 | 10/100 | 100 | 1x10⁶ |
| Compar. Ex. 7 | 5 | 100/100 | 0/100 | 2,000 | 1x10¹² |

### INDUSTRIAL APPLICABILITY

The positive photosensitive insulating resin composition according to the present invention can form cured products having excellent resolution, insulating properties, thermal shock resistance and adhesion, with the insulating properties and thermal shock resistance being particularly improved. Therefore, the present invention can provide interlaminar insulating films and surface protective films used for semiconductor elements that have these excellent properties.

## Claims

1. A positive photosensitive insulating resin composition comprising:
(A) a copolymer comprising
(A1) 10 to 99 mol% of a structural unit represented by the following formula (1) and
(A2) 90 to 1 mol% of a structural unit represented by the following formula (2) provided that the amount of total structural units of the copolymer is 100 mol%, 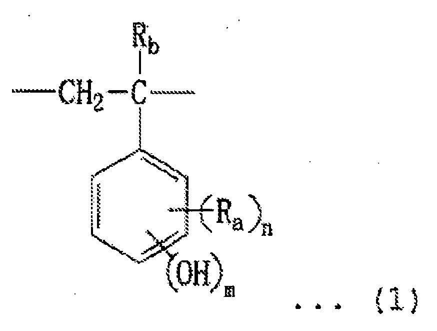 wherein Ra is an alkyl group having 1 to 4 carbon atoms, alkoxy group or aryl group, Rb is hydrogen or a methyl group, n is an integer of 0 to 3 and m is an integer of 1 to 3, 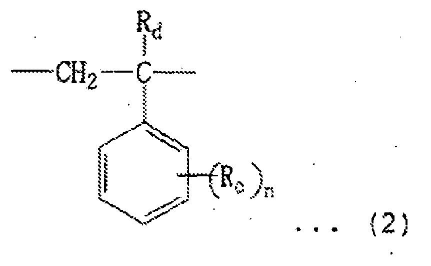 wherein Rc is an alkyl group having 1 to 4 carbon atoms, alkoxy group or aryl group, Rd is hydrogen or a methyl group and n is an integer of 0 to 3;
(B) a quinone diazide group-containing compound;
(C) at least one compound selected from the group consisting of (C1) 1,2-benzene dimethanol, 1,3-benzene dimethanol, 1,4-benzene dimethanol, 2,6-bis(hydroxymethyl)-p-cresol, 2,6-bis(hydroxylmethyl)-4-methylphenol, 5-[1,1-dimethyl-ethyl]2-hydroxy-1,3-benzene dimethanol, 2-hydroxy-1,3,5-benzene trimethanol, 2,6-dimethoxymethyl-4-methylphenol, 2,6-dimethoxymethyl-4-(1,1-dimethylethyl)phenol, 3,3'-methylene bis(2-hydroxy-5-methyl-benzene methanol), 4,4'-(1-methyl ethylidene) bis(2-methyl-6-methoxymethyl phenol), 4,4'-(1-phenol ethylidene)bis(2-hydroxyethoxy phenol), 3,3',5,5'-tetramethylol-2,2-bis(4-hydroxyphenylpropane), 3,3',5,5'-tetramethoxymethyl-2,2-bis(4-hydroxyphenylpropane), 1,2,4,5-tetramethylol benzene and 1,2,4,5-tetramethoxymethylbenzene, (C2) aromatic aldehyde compounds, (C3) aliphatic aldehyde compounds, (C4) alkyl-etherified amino group-containing compounds and (C5) epoxy group-containing compounds;
(D) a solvent; and
(E) an adhesion assistant selected from trimethoxysilylbenzoic acid, γ-methacryloxy propyl trimethoxy silane, vinyl triacetoxy silane, vinyltrimethoxy silane, γ-isocyanate propyl triethoxy silane, γ-glycidoxy propyl trimethoxy silane, β-(3,4-epoxy cyclohexyl) ethyltrimethoxy silane and 1,3,5-N-tris(trimethoxysilyl propyl) isocyanurate.

2. The positive photosensitive insulating resin composition according to claim 1, wherein the copolymer (A) consists only of 10 to 99 mol% of the structural unit (A1) and 90 to 1 mol% of the structural unit (A2) provided that the total amount of the structural units (A1) and (A2) is 100 mol%.

3. The positive photosensitive insulating resin composition according to claim 1 or 2, wherein the structural unit (A2) is represented by the following formula (2').

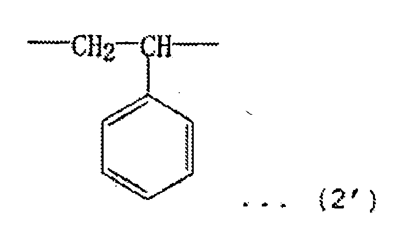

4. The positive photosensitive insulating resin composition according to any one of claims 1 to 3, which further contains a phenolic compound (a).

5. The positive photosensitive insulating resin composition according to claim 4, wherein the amount of the phenolic compound (a) is from 1 to 200 parts by weight based on 100 parts by weight of the copolymer (A).

6. The positive photosensitive insulating resin composition according to claim 4 or 5, wherein based on 100 parts by weight of the total of the copolymer (A) and the phenolic compound (a), the amount of the quinone diazide group-containing compound (B) is from 10 to 50 parts by weight and the amount of the compound (C) is from 1 to 100 parts by weight.

7. The positive photosensitive insulating resin composition according to any one of claims 1 to 6, which further contains crosslinked fine particles (F) having an average particle diameter of 30 to 500 nm, the crosslinked fine particles comprising a copolymer showing glass transition temperatures (Tg) of which at least one glass transition temperature is not higher than 0°C,
wherein the glass transition temperature (Tg) of the crosslinked fine particles (F) is determined by coagulating the crosslinked fine particles in a dispersion thereof and drying, and analyzing the particles by DSC at a temperature of from -100°C to 150°C at a temperature-elevating rate of 10°C/min.

8. The positive photosensitive insulating resin composition according to claim 7, wherein the crosslinked fine particles (F) comprise a styrene-butadiene copolymer.

9. The positive photosensitive insulating resin composition according to claim 7 or 8, wherein the amount of the crosslinked fine particles (F) is from 0.1 to 50 parts by weight based on 100 parts by weight of the total of the copolymer (A) and the phenolic compound (a).

10. A cured product obtainable by curing the positive photosensitive insulating resin composition of any one of claims 1 to 9.

## Patentansprüche

1. Positiv-lichtempfindliche Isolierharzzusammensetzung, die umfasst:
(A) ein Copolymer, das umfasst
(A1) 10 bis 99 Mol% einer Struktureinheit, die durch die folgende Formel (1) dargestellt ist, und
(A2) 90 bis 1 Mol% einer Struktureinheit, die durch die folgende Formel (2) dargestellt ist, mit der Maßgabe, dass die Menge der gesamten Struktureinheiten des Copolymers 100 Mol% ist, 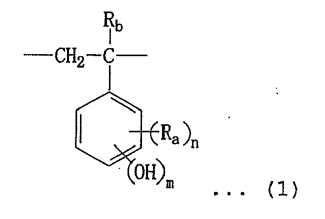 wobei Ra eine Alkylgruppe mit 1 bis 4 Kohlenstoffatomen, eine Alkoxygruppe oder eine Arylgruppe ist, Rb Wasserstoff oder eine Methylgruppe ist, n eine ganze Zahl von 0 bis 3 ist und m eine ganze Zahl von 1 bis 3 ist, 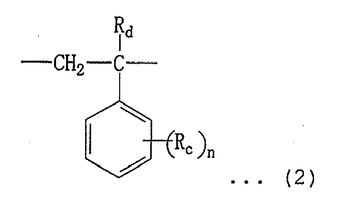 wobei Rc eine Alkylgruppe mit 1 bis 4 Kohlenstoffatomen, eine Alkoxygruppe oder eine Arylgruppe ist, Rd Wasserstoff oder eine Methylgruppe ist, und n eine ganze Zahl von 0 bis 3 ist;
(B) eine Chinondiazidgruppe-enthaltende Verbindung;
(C) zumindest eine Verbindung ausgewählt aus der Gruppe bestehend aus (C1) 1,2-Benzoldimethanol, 1,3-Benzoldimethanol, 1,4-Benzoldimethanol, 2,6-bis(Hydroxymethyl)-p-cresol, 2,6-bis(Hydroxylmethyl)-4-methylphenol, 5-[1,1-Dimethyl-ethyl]-2-hydroxy-1,3-benzoldimethanol, 2-Hydroxy-1,3,5-benzoltrimethanol, 2,6-Dimethoxymethyl-4-methylphenol, 2,6-Dimethoxymethyl-4-(1,1-dimethylethyl)phenol, 3,3'-Methylen-bis(2-Hydroxy-5-methyl-benzolmethanol), 4,4'-(1-Methylethyliden) bis(2-Methyl-6-methoxymethylphenol), 4,4'-(1-Phenylethyliden)-bis(2-Hydroxyethoxyphenol), 3,3',5,5'-Tetramethylol-2,2-bis(4-hydroxyphenylpropan), 3,3',5,5'-Tetramethoxymethyl-2,2-bis(4-hydroxyphenylpropan), 1,2,4,5-Tetramethylolbenzol und 1,2,4,5-Tetramethoxymethylbenzol, (C2) aromatischen Aldehydverbindungen, (C3) aliphatischen Aldehydverbindungen, (C4) Alkyl-veretherten Aminogruppeenthaltenden Verbindungen und (C5) Epoxidgruppeenthaltenden Verbindungen;
(D) ein Lösungsmittel; und
(E) einen Adhäsionshilfsstoff ausgewählt aus Trimethoxysilylbenzoesäure, γ-Methacryloxypropyltrimethoxysilan, Vinyltriacetoxysilan, Vinyltrimethoxysilan, γ-Isocyanatpropyltriethoxysilan, γ-Glycidoxypropyltrimethoxysilan, β-(3,4-Epoxycyclohexyl)ethyltrimethoxysilan und 1,3,5-N-tris(Trimethoxysilylpropyl)isocyanurat.

2. Positiv-lichtempfindliche Isolierharzzusammensetzung nach Anspruch 1, wobei das Copolymer (A) nur aus 10 bis 99 Mol% der Struktureinheit (A1) und 90 bis 1 Mol% der Struktureinheit (A2) besteht, mit der Maßgabe, dass die Gesamtmenge der Struktureinheiten (A1) und (A2) 100 Mol% ist.

3. Positiv-lichtempfindliche Isolierharzzusammensetzung nach Anspruch 1 oder 2, wobei die Struktureinheit (A2) durch die folgende Formel (2') dargestellt ist.

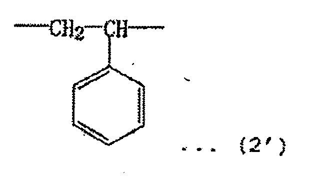

4. Positiv-lichtempfindliche Isolierharzzusammensetzung nach einem der Ansprüche 1 bis 3, welche ferner eine phenolische Verbindung (a) enthält.

5. Positiv-lichtempfindliche Isolierharzzusammensetzung nach Anspruch 4, wobei die Menge der phenolischen Verbindung (a) von 1 bis 200 Gewichtsteile basierend auf 100 Gewichtsteilen des Copolymers (A) beträgt.

6. Positiv-lichtempfindliche Isolierharzzusammensetzung nach Anspruch 4 oder 5, wobei, basierend auf 100 Gewichtsteilen der Gesamtheit des Copolymers (A) und der phenolischen Verbindung (a), die Menge der Chinondiazidgruppe-enthaltende Verbindung (B) von 10 bis 50 Gewichtsteile beträgt und die Menge der Verbindung (C) von 1 bis 100 Gewichtsteile beträgt.

7. Positiv-lichtempfindliche Isolierharzzusammensetzung nach einem der Ansprüche 1 bis 6, welche ferner vernetzte Feinteilchen (F) mit einem durchschnittlichen Teilchendurchmesser von 30 bis 500 nm enthält, wobei die vernetzten Feinteilchen ein Copolymer umfassen, das Glasübergangstemperaturen (Tg) zeigt, von welchen zumindest eine Glasübergangstemperatur nicht höher als 0°C ist,
wobei die Glasübergangstemperatur (Tg) der vernetzten Feinteilchen (F) bestimmt ist durch Koagulieren der vernetzten Feinteilchen in einer Dispersion davon und Trocknen, und Analysieren der Teilchen durch DSC bei einer Temperatur von -100°C bis 150°C bei einer Temperatursteigerungsrate von 10°C/min.

8. Positiv-lichtempfindliche Isolierharzzusammensetzung nach Anspruch 7, wobei die vernetzten Feinteilchen (F) ein Styrol-Butadien-Copolymer umfassen.

9. Positiv-lichtempfindliche Isolierharzzusammensetzung nach Anspruch 7 oder 8, wobei die Menge der vernetzten Feinteilchen (F) von 0,1 bis 50 Gewichtsteile basierend auf 100 Gewichtsteilen der Gesamtheit des Copolymers (A) und der phenolischen Verbindung (a) beträgt.

10. Gehärtetes Produkt, das erhältlich ist durch Aushärten der positiv-lichtempfindlichen Isolierharzzusammensetzung nach einem der Ansprüche 1 bis 9.

## Revendications

1. Composition de résine d'isolation photosensible positive comprenant :
(A) un copolymère comprenant
(A1) 10 à 99% en moles d'une unité structurale représentée par la formule (1) suivante et
(A2) 90 à 1% en moles d'une unité structurale représentée par la formule (2) suivante sous réserve que la quantité d'unités structurales totales du copolymère soit 100% en moles, 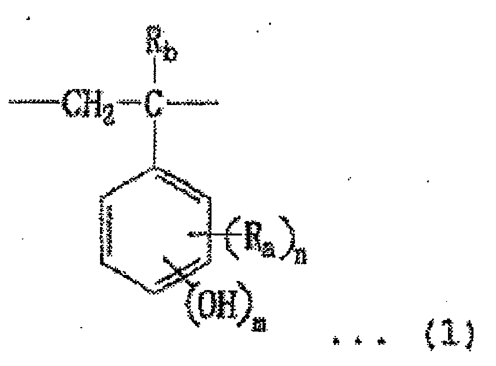 dans laquelle Ra est un groupe alkyle ayant 1 à 4 atomes de carbone, un groupe alcoxy ou un groupe aryle, Rb est un hydrogène ou un groupe méthyle, n est un entier de 0 à 3 et m est un entier de 1 à 3, 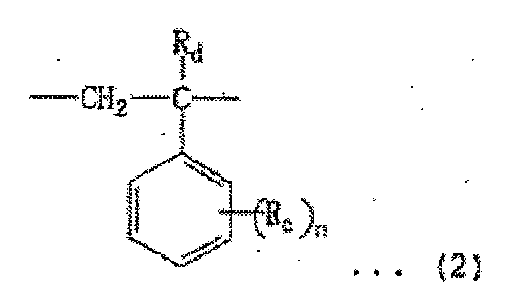 dans laquelle Rc est un groupe alkyle ayant 1 à 4 atomes de carbone, un groupe alcoxy ou un groupe aryle, Rd est un hydrogène ou un groupe méthyle et n est un entier de 0 à 3 ;
(B) un composé contenant un groupe quinone diazide ;
(C) au moins un composé choisi parmi le groupe consistant en (C1) le 1,2-benzènediméthanol, le 1,3-benzènediméthanol, le 1,4-benzènediméthanol, le 2,6-bis(hydroxyméthyl)-p-crésol, le 2,6-bis(hydroxyméthyl)-4-méthylphénol, le 5-(1,1-diméthyl-éthyl)-2-hydroxy-1,3-benzènediméthanol, le 2-hydroxy-1,3,5-benzènetriméthanol, le 2,6-diméthoxyméthyl-4-méthylphénol, le 2,6-diméthoxyméthyl-4-(1,1-diméthyléthyl)phénol, le 3,3'-méthylène-bis(2-hydroxy-5-méthyl-benzèneméthanol), le 4-4'-(1-phényléthylidène)bis(2-méthyl-6-méthoxyméthylphénol), le 4-4'-(1-phényléthylidène)bis(2-hydroxyéthoxyphénol), le 3,3',5,5'-tétraméthylol-2,2-bis(4-hydroxyphénylpropane), le 3,3',5,5'-tétraméthoxyméthyl-2,2-bis(4-hydroxyphénylpropane), le 1,2,4,5-tétraméthylolbenzène et le 1,2,4,5-tétraméthoxyméthylbenzène, (C2) des composés aldéhyde aromatiques, (C3) des composés aldéhyde aliphatiques, (C4) des composés contenant un groupe amino éthérifié avec un alkyle et (C5) des composés contenant un groupe époxy ;
(D) un solvant ; et
(E) un agent d'adhérence choisi parmi l'acide triméthoxysilylbenzoïque, le γ-méthacryloxypropyltriméthoxysilane, le vinyltriacétoxysilane, le vinyltriméthoxysilane, le γ-isocyanatepropyltriéthoxysilane, le γ-glycidoxypropyltriméthoxysilane, le β-(3,4-époxycyclohexyl)-éthyltriméthoxysilane et le 1,3,5-N-tris(triméthoxysilylpropyl)isocyanurate.

2. Composition de résine d'isolation photosensible positive selon la revendication 1, dans laquelle le copolymère (A) ne consiste qu'en 10 à 99% en moles de l'unité structurale (A1) et 90 à 1% en moles de l'unité structurale (A2) sous réserve que la quantité totale des unités structurales (A1) et (A2) soit 100% en moles.

3. Composition de résine d'isolation photosensible positive selon la revendication 1 ou 2, dans laquelle l'unité structurale (A2) est représentée par la formule (2') suivante

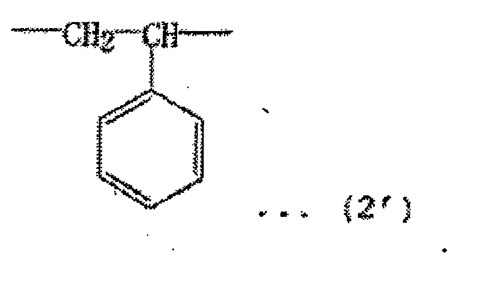

4. Composition de résine d'isolation photosensible positive selon l'une quelconque des revendications 1 à 3, qui contient en outre un composé phénolique (a).

5. Composition de résine d'isolation photosensible positive selon la revendication 4, dans laquelle la quantité du composé phénolique (a) est de 1 à 200 parties en poids sur la base de 100 parties en poids du copolymère (A).

6. Composition de résine d'isolation photosensible positive selon la revendication 4 ou 5, dans laquelle, sur la base de 100 parties en poids du total du copolymère (A) et du composé phénolique (a), la quantité du composé contenant un groupe quinone diazide (B) est de 10 à 50 parties en poids et la quantité du composé (C) est de 1 à 100 parties en poids.

7. Composition de résine d'isolation photosensible positive selon l'une quelconque des revendications 1 à 6, qui contient en outre des particules fines réticulées (F) ayant un diamètre moyen de particules de 30 à 500 nm, les particules fines réticulées comprenant un copolymère affichant des températures de transition vitreuse (Tg) dont au moins une température de transition vitreuse n'est pas supérieure à 0°C,
dans laquelle la température de transition vitreuse (Tg) des particules fines réticulées (F) est déterminée par coagulation des particules fines réticulées dans une dispersion de celles-ci et séchage, et par analyse des particules par DSC à une température de -100°C à 150°C à une vitesse d'élévation de température de 10°C/min.

8. Composition de résine d'isolation photosensible positive selon la revendication 7, dans laquelle les particules fines réticulées (F) comprennent un copolymère de styrène-butadiène.

9. Composition de résine d'isolation photosensible positive selon la revendication 7 ou 8, dans laquelle la quantité des particules fines réticulées (F) est de 0,1 à 50 parties en poids sur la base de 100 parties en poids du total du copolymère (A) et du composé phénolique (a).

10. Produit durci pouvant être obtenu par durcissement de la composition de résine d'isolation photosensible positive selon l'une quelconque des revendications 1 à 9.
